# EUROPEAN PATENT SPECIFICATION

(11) **EP 0 767 533 B1**
(45) Date of publication and mention of the grant of the patent: **12.07.2000**
(21) Application number: 96910212.8
(22) Date of filing: 19.04.1996
(51) Int. Cl.: H03D 3/00, H03D 3/24

(54) **RF APPARATUS**
FUNKGERÄT
APPAREIL DE RADIO

(30) Priority: 20.04.1995 JP 9486295
(43) Date of publication of application: 09.04.1997
(73) Proprietor: MATSUSHITA ELECTRIC INDUSTRIAL CO., LTD., Kadoma-shi, Osaka-fu, 571 (JP)
(72) Inventor: YASUDA, Masashi, Nishikasugai-gun, Aichi 452 (JP); FUJISHIMA, Akira, Ichinomiya-shi, Aichi 491 (JP)
(74) Representative: Crawford, Andrew Birkby
(86) International application number: JP9601077
(87) International publication number: WO9633554

(56) References cited:
- EP-A- 0 645 881
- EP-A- 0 645 882
- JP-A- 2 280 492
- JP-A- 5 075 348
- JP-A- 5 090 842
- JP-A- 7 066 630
- JP-A- 61 141 208
- JP-B- 4 020 557
- JP-B- 60 027 480
- JP-U- 61 206 333

## Description

### SPECIFICATION

### [TECHNICAL FIELD]

This invention relates to a high-frequency apparatus having a FM demodulator.

### [BACKGROUND TECHNOLOGY]

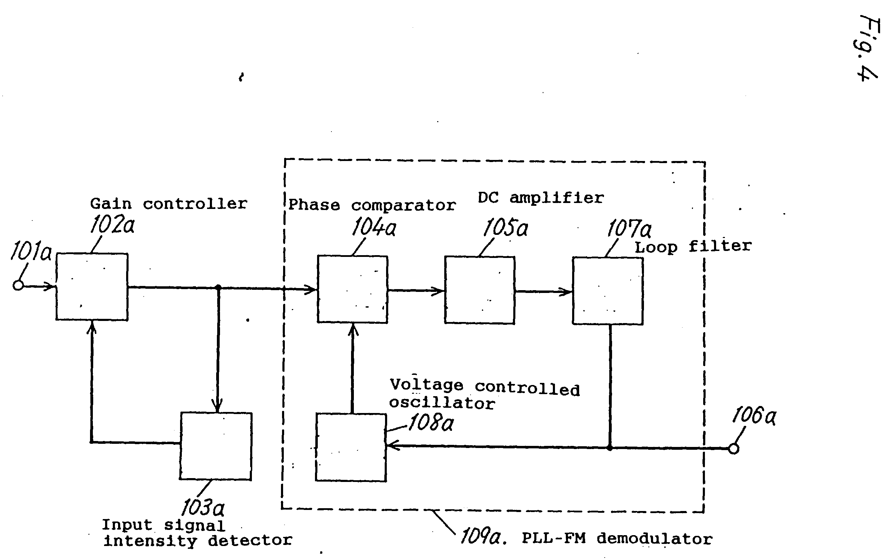

FIG. 4 shows a block diagram of high-frequency apparatus designed for a conventional FM broadcast receiver having a PLL-FM demodulator.

The conventional high-frequency apparatus comprises input terminal 101a, gain controller 102a connected to said input terminal 101a, phase comparator 104a where one of its inputs is connected to the output of said gain-controller 102a, DC- amplifier 105a connected to the output of said phase comparator 104a, loop filter 107a connected to the output of said DC amplifier 105a, output terminal 106a connected to the output of said loop filter 107a, voltage control oscillator 108a connected between the output of said
loop filter 107a and the other input of said phase comparator 104a, and input signal intensity detector 103a connected between the output of said gain controller 102a and the control input terminal of said gain controller 102a.

Furthermore, PLL-FM demodulator 109a comprises phase comparator 104a, DC-amplifier 105a, loop-filter 107a, and voltage control oscillator 108a. The operations of thus constructed high-frequency apparatus are now explained below.

As the output of gain controller 102a is controlled by the control voltage generated by input signal intensity detector 103a, the input signal of constant intensity is given to phase comparator 104a.

The oscillator signal generated by voltage control oscillator 108a is inputted to the other input of said phase comparator 104a, and the phase difference with the output of said gain controller 102a is determined, and its output is inputted into DC-amplifier 105a.

The output of DC-amplifier 105a is inputted into voltage control oscillator 108a and is outputted from output terminal 106a simultaneously, through loop filter 107a.

The demodulating characteristics obtained by PLL-FM demodulator 109a is now explained below. Said PLL-FM demodulator 109a operates as threshold improving type of FM demodulator which has a good effect to improve the ratio of output noise to output signal against the ratio of input noise to input signal. And the maximum improvement of threshold is achieved by matching the demodulation characteristics to the characteristics of input FM signal.

This means that the threshold effect can not be obtained sufficiently or the demodulating output containing greater noise could be obtained occasionally, when the characteristics of input signal is changed.

In PLL-FM demodulator 109a, the demodulation bandwidth to the input signal is determined by the total loop gain obtained by phase comparator 104a, DC-amplifier 105a, loop filter 107a, and voltage control oscillator 108a. Thus, the noise signal out of the demodulation bandwidth can be removed and the improvement of threshold can be achieved, when only the signal corresponding to the demodulation bandwidth is selectively FM demodulated.

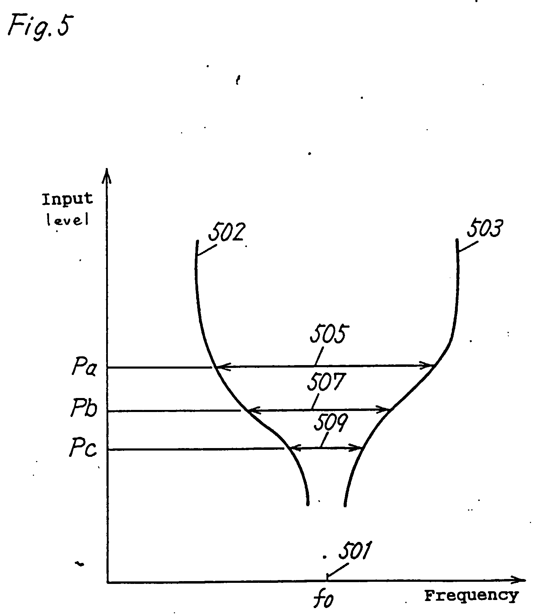

Fig. 5 shows a relationship between the input signal intensities to the phase comparator 104a and the demodulation bandwidth. The horizontal axis of Fig. 5 shows a degree of frequency detuning, and the vertical axis thereof shows the input signal intensity. In here, the demodulation center frequency is indicated by 501, the lower demodulation band characteristics is indicated by 502, and the upper demodulation band characteristics is indicated by 503.

That is, the demodulation bandwidth indicated by 507 is obtained when the input signal intensity is Pb, and a demodulation bandwidth becomes wider as shown by 505 when the input signal intensity is Pa, and it becomes narrower as shown by 509 when the input signal intensity is Pc.

The signal out of the demodulation bandwidth is not demodulated. However, not only the signal but the noise component are demodulated within the demodulation bandwidth. Therefore, the demodulation bandwidth narrower as possible should be advantageous to the noise suppression, and the improvement of threshold is possible by performing the bandwidth control effectively.

That means that a gain of gain controller should be so controlled holding the input signal intensity at Pb when the modulation bandwidth equals to demodulation bandwidth 507. However, there could be cases where the actual bandwidth of modulation signal is more than demodulation bandwidth 507. In this case, the gain should be controlled holding the input signal intensity at Pa to obtain the demodulation bandwidth 505.

However, widening of demodulation bandwidth may increase the demodulation noise component level, and may cause also partial demodulation of the adjacent channel signals. Since this components may be added as disturbing components, the threshold level would be further deteriorated.

On the other hand, the essential signal components would be sacrificed when the modulation signal corresponding to demodulation bandwidth 505 is inputted under the condition of the setting of demodulation bandwidth 507. At this time, PLL-FM demodulator would be stepped out causing extremely large noises.

As shown in above, there could be problems of unsurpassed high level threshold noises caused by wide and unchanged demodulation bandwidth of PLL-FM demodulator 109a despite the change of modulation degree of the input signal, or by the step-out of PLL-FM demodulator 109a due to the narrow demodulation bandwidth.

JP-A-61-141208 discloses high frequency apparatus having an input terminal, a gain controller connected to the input terminal, a phase comparator having one of its inputs connected to the gain controller, a loop filter connected to the output of the phase comparator, an output terminal connected to the output of the loop filter, a voltage controlled oscillator connected between the output of the loop filter and the other input of the phase comparator, an input signal intensity detector connected to the output of the gain controller, a detector connected to the output of the loop filter, a switch connected to the output of the detector, a composite circuit having one of its inputs connected to the output of the switch and the other input connected to the output of a input signal intensity detector and a control terminal connected to the ON-OFF control input of said switch. In this arrangement the output of the composite signal is used as a gain control input for a second series connected gain control amplifier. There is further provided a bandpass filter connected between the output of the low pass loop filter and the detector and accordingly in this prior art the gain control is not altered instantly according to the modulation degree of the input signal.

### [DISCLOSURE OF THE INVENTION]

Thus, the object of this invention is to offer a high-frequency apparatus generating no high-level noise due to the step-out of synchronization, and realizing effective improvements of threshold by detecting the degree of FM modulation of input signal and by adapting the demodulation bandwidth of PLL-FM demodulator to the detected degree of FM modulation.

The present invention provides a high-frequency apparatus comprising an input terminal, a gain controller connected to said input terminal, a phase comparator where one of its inputs is connected to the output of said gain controller, a DC-amplifier connected to the output of said phase comparator, a loop filter connected to the output of said DC-amplifier, an output terminal providing a demodulated signal connected to the output of said loop filter, a voltage control oscillator connected between the output of said loop filter and the other input of said phase comparator, an input signal intensity detector connected to the output of said gain controller, a modulation detector connected directly to the output of said loop filter and arranged to detect the degree of FM modulation in a signal at the output of said loop filter, a switch connected to the output of said modulation detector, a composite circuit having one of its inputs connected to the output of said switch and the other input connected to the output of said input signal intensity detector, and a control terminal connected to an ON-OFF control input of said switch, wherein said gain controller has a gain control terminal which is connected to the output of said composite circuit, which output varies according to said modulation degree, whereby demodulation bandwidth of the apparatus varies synchronously with the degree of FM modulation.

This high-frequency apparatus improves the threshold sufficiently without producing large noise by detecting the degree of modulation of input signal and adapts the PLL-FM demodulation bandwidth instantaneously to the detected signal.

Therefore, the output of the gain control circuit inputted to the phase comparator can be controlled suitably matching to the demodulation bandwidth according to the modulation degree of input signal, producing no problem of large noise caused by the step-out of synchronization, and the improvement of threshold is performed constantly. Moreover, the disturbance noises due to the adjacent channel signals can be effectively suppressed. Furthermore, the gain control circuit can be simplified by compositting the gain control signals.

### [BRIEF EXPLANATION OF THE DRAWINGS]

Fig. 1 shows a block diagram of high frequency apparatus which is an embodiment of the invention, Fig. 2 shows a characteristics curve showing a relationship between the demodulation bandwidth and the input signal intensity of this invention, Fig. 3 shows a characteristics showing adjacent channel disturbances of this invention, Fig. 4 shows a block diagram of conventional high-frequency apparatus, and Fig. 5 shows a characteristics showing the relationship between the demodulation bandwidth and the input signal intensity of conventional high frequency apparatus.

### [BEST STRUCTURE REALIZING THE INVENTION]

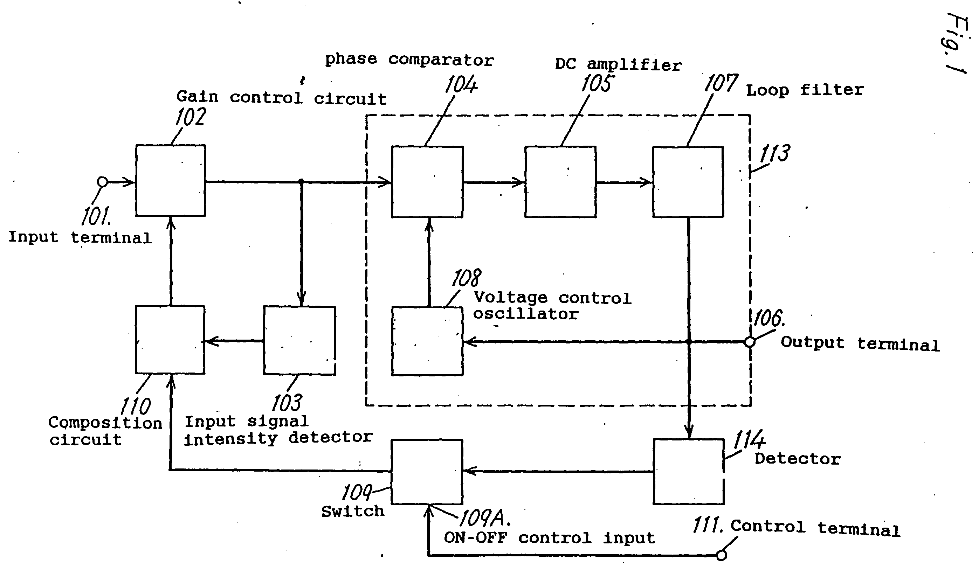

An embodiment of the present invention is now explained by referring the attached drawings. The high-frequency apparatus of the invention shown in Fig. 1 comprises input terminal 101, gain controller 102 connected to input terminal 101, phase comparator 104 where one of its inputs is connected to the output of gain controller 102, DC-amplifier 105 connected to the output of phase comparator 104, loop filter 107 connected to the output of DC-amplifier 105, output terminal 106 connected to the output of loop filter 107, voltage control oscillator 108 connected between the output of loop filter 107 and the other input of phase comparator 104, input signal intensity detector 103 connected to the output of gain controller 102, detector 114 detecting the degree of FM modulation connected to the output of loop filter 107, switch 109 connected to the output of detector 114, and composite circuit 110 wherein one of the its inputs is connected to the output of switch 109 and the other input is connected to the output of said input signal intensity detector 103, control terminal 111 connected to ON-OFF control input 109A of said switch 109, and the output of said composite circuit 110 is connected to the gain control terminal of gain control circuit 102. Beside, 113 is a FM demodulation means.

The operations of the above-constructed high-frequency apparatus are now explained below. The signal inputted from input terminal 101 is inputted into the other input of phase comparator 104 through gain controller 102.

On the other hand, a control voltage according to the input signal intensity is generated by the input signal intensity detector 103, and the output of gain control circuit 102 is controlled by the control voltage. Therefore, an input signal of constant voltage is inputted into phase comparator 104.

While an oscillator signal from voltage control oscillator 108 is inputted into the other input of phase comparator 104, its phase is compared with that of the output of gain controller 102, and its output is inputted into DC-amplifier 105. The output of DC-amplifier 105 is inputted into voltage control oscillator 108 through loop filter 107, and its demodulated output is outputted through output terminal 106 at the same time.

While demodulated output is given to composite circuit 110 as one of its inputs through detector 114 detecting the degree of FM modulation and switch 109, the output of input signal intensity detector 103 is inputted into the other input of composite circuit 110, and composite circuit 110 produces control voltage of gain control circuit 102 and outputs them. Switch 109 controls its ON-OFF not only by the control signal from control terminal 111, but by the control signal from the detector (not shown) detecting the special FM modulation signal. The special FM modulation signal in here may mean a MUSE signal in satellite broadcasting, and switch 109 can be turned off upon detecting the MUSE signal.

The signal outputted through switch 109 is inputted into composite circuit 110. In composite circuit 110, signals are compositted in a direction increasing the gain of gain controller 102 when the amplitude of demodulated output is increased. On the other hand, signals are compositted in a direction decreasing the gain of gain controller 102 when the amplitude of demodulated output is decreased.

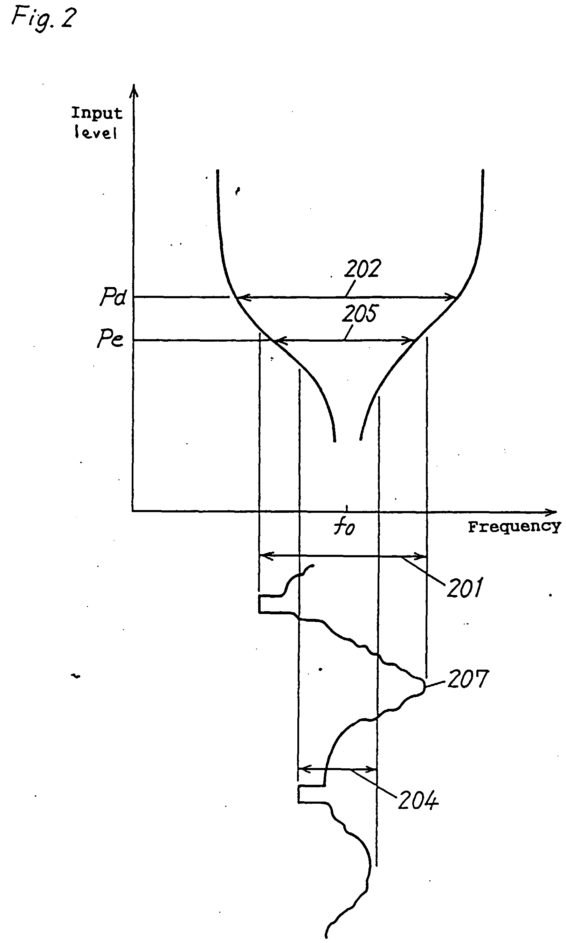

Then, the operations of demodulation bandwidth and gain control are now explained referring Fig. 2. Gain controller 102 is controlled by the composite control signal outputted from composite circuit 110. For example, when a signal of large modulation degree comes, or a demodulated output of large amplitude 201 comes in, the input into phase comparator 104 becomes large yielding a demodulation bandwidth 202 corresponding to input signal intensity Pd.

That is, the desired signal bandwidth can be obtained with no sacrifice since the demodulation bandwidth becomes wider in accordance with the inputted FM modulation signal.

In addition to these, when a signal of small modulation degree or a demodulated output of small amplitude 204 comes in, the input to phase comparator 104 is smaller yielding demodulation bandwidth 205 corresponding to input signal intensity Pe. That is, since the modulation bandwidth becomes narrower in accordance to the inputted FM modulation signal, the signal demodulation is made at an optimum demodulation bandwidth and the improvement of threshold is performed.

As shown above, as the gain control in accordance with the modulation degree is made changed instantly with the change of the input signal, the improvement of threshold can be optimized constantly.

Moreover, for the signals of adjacent channels or next adjacent channels, the gain control can not be controlled by the signals of adjacent or next adjacent channels, since the amplitude of demodulated output is less than the amplitude of demodulated output of the desired FM demodulation signals. That is, since the demodulation bandwidth is changed in a way restricting the adjacent channel signal or next adjacent channel signals, the interference due to the adjacent channel signals or next adjacent channel signals can be suppressed.

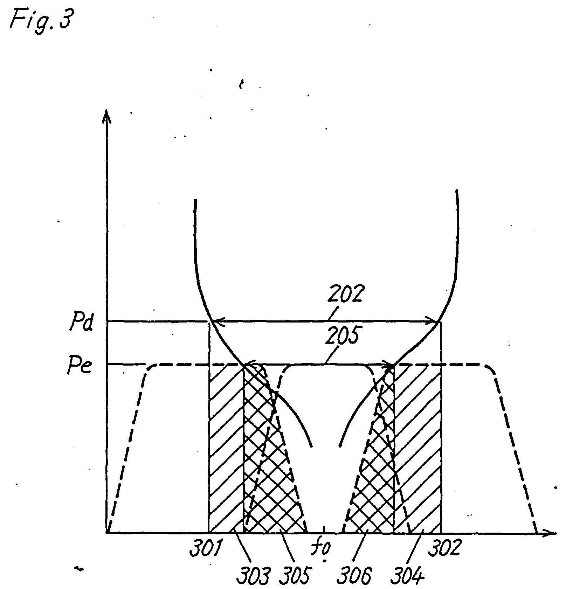

Then, the effect of suppression of adjacent channel signals is now explained referring Fig. 3. 301 shows a signal in the lower adjacent channel and 302 shows a signal in the upper adjacent channel. Assuming the demodulation bandwidth is kept at constant bandwidth 202, since the left hatched line part 303 of the lower adjacent channel and the left hatched line part 304 of the upper adjacent channel come in the demodulation bandwidth, these signals act as the disturbances deteriorating the threshold.

On the other hand, the disturbances due to the adjacent channel signals can be suppressed since the demodulation bandwidth becomes narrower producing demodulation bandwidth 205 in accordance to the modulation degree, and disturbance signals are limited small by the right hatched line part 305 of the lower adjacent channel and the right hatched line part 306 of the upper adjacent channel.

As above described, since the demodulation bandwidth is changed in synchronizing with the desired FM modulation signal, the signals of adjacent channel or the signals of next adjacent channels can be suppressed in average during demodulation of a total picture frame.

### [INDUSTRIAL UTILITY]

As above explained, the high-frequency apparatus of this invention consists of a detector detecting the degree of FM modulation and being connected to the output of loop filter; a switch connected to the output of said detector; a composite circuit of which one of inputs is connected to the output of said switch and the other input is connected to the output of said input signal intensity detector, and the output is connected to the gain control terminal of said gain control circuit; and a control terminal connected to the ON-OFF control input of said switch.

Since said composite circuit produces a proper control voltage for demodulation bandwidth and a gain of said gain control circuit can be controlled by said control voltage, an output of said gain control circuit, i.e. an input of a phase comparator, can be adjusted to the optimum intensity for the degree of input signal modulation, and the apparatus of this invention can make constant improvement of threshold without producing large noise due to step-out of synchronization.

Moreover, the disturbance due to adjacent channel signals can be suppressed effectively, and the structure of gain control circuit can be simplified by compositing the gain control signals.

### [Glossary of The Terms]

- 101: input terminal,
- 102: gain control circuit,
- 103: input signal intensity detector,
- 104: phase comparator,
- 105: DC amplifier,
- 106: output terminal,
- 107: loop filter,
- 108: voltage control oscillator,
- 109: switch,
- 109A: ON-OFF control input,
- 110: composition circuit,
- 111: control terminal,
- 113: FM demodulator,
- 201: amplitude,
- 202: demodulation bandwidth,
- 204: amplitude,
- 205: demodulation bandwidth,
- 301: lower neighboring channel,
- 302: upper neighboring channel,
- 303: left hatched line part,
- 304: left hatched line part,
- 305: right hatched line part,
- 396: right hatched line part,
- 501: demodulation center frequency,
- 502: lower demodulation bandwidth characteristics,
- 503: upper demodulation bandwidth characteristics,
- 505: demodulation bandwidth,
- 507: demodulation bandwidth,
- 509: demodulation bandwidth.
- 101a: input terminal,
- 102a: gain control circuit,
- 103a: input signal intensity detecting circuit,
- 104a: phase comparator,
- 105a: DC amplifier,
- 106a: output terminal,
- 107a: loop filter,
- 108a: voltage control oscillator,
- 109a: PLL-FM demodulator.

## Claims

1. A high-frequency apparatus comprising an input terminal (101), a gain controller (102) connected to said input terminal, a phase comparator (104) where one of its inputs is connected to the output of said gain controller, a DC-amplifier (105) connected to the output of said phase comparator, a loop filter (107) connected to the output of said DC-amplifier, an output terminal (106) providing a demodulated signal connected to the output of said loop filter, a voltage control oscillator (108) connected between the output of said loop filter and the other input of said phase comparator, an input signal intensity detector (103) connected to the output of said gain controller, a modulation detector (114) connected directly to the output of said loop filter and arranged to detect the degree of FM modulation in a signal at the output of said loop filter, a switch (109) connected to the output of said modulation detector (114), a composite circuit (110) having one of its inputs connected to the output of said switch and the other input connected to the output of said input signal intensity detector, and a control terminal (111) connected to an ON-OFF control input of said switch, wherein said gain controller has a gain control terminal which is connected to the output of said composite circuit, which output varies according to said modulation degree, whereby demodulation bandwidth of the apparatus varies synchronously with the degree of FM modulation.

2. A high-frequency apparatus according to claim 1 wherein the ON-OFF control of said switch is made by a control signal obtained from said control terminal connected to said switch.

3. A high-frequency apparatus according to claim 1 wherein said switch is turned off by a MUSE signal in satellite broadcasting.

## Patentansprüche

1. Hochfrequenzgerät mit: einem Eingangsanschluß (101), einem an den Eingangsanschluß angeschlossenen Verstärkungsregler (102), einem Phasenvergleicher (104), von dem einer seiner Eingänge an den Ausgang des Verstärkungsreglers angeschlossen ist, einem an den Ausgang des Phasenvergleichers angeschlossenen Gleichspannungsverstärker (105), einem an den Ausgang des Gleichspannungsverstärkers angeschlossenen Schleifenfilter (107), einem an den Ausgang des Schleifenfilters angeschlossenen Ausgangsanschluß (106), der ein demoduliertes Signal bereitstellt, einem spannungsgeregelten Oszillator (108), der zwischen dem Ausgang des Schleifenfilters und dem anderen Eingang des Phasenvergleichers angeschlossen ist, einem an den Ausgang des Verstärkungsreglers angeschlossenen Eingangssignalstärkedetektor (103), einem Modulationsdetektor (114), der direkt an den Ausgang des Schleifenfilters angeschlossen und so angeordnet ist, daß er den Grad der FM-Modulation in einem Signal am Ausgang des Schleifenfilters erfaßt, einem an den Ausgang des Modulationsdetektors (114) angeschlossenen Schalter (109), einer Verbundschaltung (110), deren einer Eingang an den Ausgang des Schalters und deren anderer Eingang an den Ausgang des Eingangsignalstärkedetektors angeschlossen ist, und einem Steueranschluß (111), der mit einem EIN-AUS-Steuereingang des Schalters verbunden ist, wobei der Verstärkungsregler einen Verstärkungsregelanschluß hat, der an den Ausgang der Verbundschaltung angeschlossen ist, deren Ausgangssignal sich entsprechend dem Grad der Modulation ändert, wodurch sich die Demodulationsbandbreite des Gerätes synchron mit dem Grad der FM-Modulation ändert.

2. Hochfrequenzgerät nach Anspruch 1, wobei die EIN-AUS-Steuerung des Schalters über ein Steuersignal aus dem an den Schalter angeschlossenen Steueranschluß erfolgt.

3. Hochfrequenzgerät nach Anspruch 1, wobei der Schalter im Satellitenrundfunk mittels eines MUSE-Signals ausgeschaltet wird.

## Revendications

1. Appareil haute fréquence comprenant une borne d'entrée (101), un dispositif (102) de commande de gain connecté à ladite borne d'entrée, un comparateur de phase (104) dont une des entrées est connectée à la sortie dudit dispositif de commande de gain, un amplificateur en courant continu (105) connecté à la sortie dudit comparateur de phase, un filtre en boucle (107) connecté à la sortie dudit amplificateur en courant continu, une borne de sortie (106) fournissant un signal démodulé et connectée à la sortie dudit filtre en boucle, un oscillateur commandé par tension (108) qui est connecté entre la sortie dudit filtre en boucle et l'autre entrée dudit comparateur de phase, un détecteur (103) d'intensité de signal d'entrée qui est connecté à la sortie dudit dispositif de commande de gain, un détecteur de modulation (114) connecté directement à la sortie dudit filtre en boucle et conçu pour détecter le degré de modulation de fréquence (FM) dans un signal se trouvant sur la sortie dudit filtre en boucle, un commutateur (109) connecté à la sortie dudit détecteur de modulation (114), un circuit composite (110) dont une des entrées est connectée à la sortie dudit commutateur et dont l'autre entrée est connectée à la sortie dudit détecteur d'intensité de signal d'entrée, et une borne de commande (111) connectée à une entrée de commande de type "ouvert-fermé" dudit commutateur, où le dispositif de commande de gain possède une borne de commande de gain qui est connectée à la sortie dudit circuit composite, dont le signal de sortie varie en fonction dudit degré de modulation, de sorte que la largeur de bande de démodulation de l'appareil varie de façon synchrone avec le degré de modulation de fréquence.

2. Appareil haute fréquence selon la revendication 1, où la commande de type "ouvert-fermé" dudit commutateur est effectuée par un signal de commande qui est obtenu de ladite borne de commande connectée audit commutateur.

3. Appareil haute fréquence selon la revendication 1, où ledit commutateur est mis dans l'état ouvert par un signal MUSE en diffusion par satellite.
